# DEMANDE DE BREVET EUROPEEN

(11) **EP 0 619 696 A1**
(43) Date de publication de la demande: **12.10.1994**
(21) Numéro de dépôt: 94400750.9
(22) Date de dépôt: 06.04.1994
(51) Int. Cl.: H05K 7/10, H01R 13/24, H01R 23/72

(54) **Connecteur intermédiaire entre carte de circuit imprimé et substrat à circuits électriques**

(30) Priorité: 09.04.1993 FR 9304264
(71) Demandeur: FRAMATOME CONNECTORS INTERNATIONAL, 92084 Paris La Défense (FR)
(72) Inventeur: Bargain, Raymond, F-78500 Sartrouville (FR); Riverie, Jean, F-91470 Limours (FR); Ollivier, Jean-François, F-78000 Versailles (FR)
(74) Mandataire: Fort, Jacques

(57) **Abrégé**

Le connecteur intermédiaire est destiné à être monté sur une carte de circuit imprimé (12) de façon qu'une première face du connecteur s'appuie sur la carte et à recevoir, sur une seconde face, un substrat (14) de circuit électronique en reliant des plots de contact prévus sur le substrat (14) à des pistes de la carte (12). Le connecteur comprenant un support isolant (20) dans lequel sont ménagés des passages régulièrement espacés et des contacts électriques de signal (22), chacun destiné à relier un plot et une piste, disposés dans certains au moins des passages. Chaque contact (22) est constitué par un feuillard découpé, ayant une branche (28) rigide d'accrochage sur le support et une branche souple en forme de S. Le passage est délimité par une cloison destinée à recevoir l'appui coulissant de la branche rigide et présentant des épaulements de butée séparées d'un intervalle déterminé (eo), la surface de butée la plus proche de la première face étant à une hauteur prédéterminée (ho) par rapport à cette dernière. La branche rigide, dirigée le long du passage, comporte deux épaulements de butée en regard, séparés d'un intervalle déterminé (eo) supérieur à (e). La saillie (h) du contact à partir de l'épaulement le plus proche de la seconde face est inférieure à (ho).

## Description

La présente invention a pour objet un connecteur intermédiaire destiné à être intercalé entre une carte de circuit imprimé et un substrat portant des circuits électroniques. Elle trouve une application particulièrement importante, bien que non exclusive, dans les dispositifs à substrat en céramique et notamment à substrat portant plusieurs circuits intégrés.

L'invention concerne plus particulièrement un connecteur intermédiaire du genre décrit dans le brevet FR 90 13996 (FR-A-2 669 149), conforme au préambule de la revendication 1.

L'un des problèmes que pose la réalisation de tels connecteurs est l'obtention de contraintes régulières sur les contacts lorsque le connecteur est monté entre une carte et un substrat.

L'invention vise à fournir un connecteur du genre ci-dessus défini répondant mieux que ceux antérieurement connus aux exigences de la pratique et notamment assurant la régularité de pression souhaitable. Elle propose en conséquence un connecteur du type ci-dessus défini, conforme à la partie caractérisante de la revendication 1.

Dans cette disposition, chacun des contacts se positionne automatiquement de façon telle que les pressions exercées de chaque côté du contact s'équilibrent et que les forces de pression qui s'exercent sur les différents contacts s'équilibrent également.

L'invention propose également d'autres dispositions, avantageusement utilisables avec les précédentes mais pouvant l'être indépendamment. Toutes ces dispositions apparaîtront mieux à la lecture de la description qui suit d'un mode particulier de réalisation, donné à titre d'exemple.

La description se réfère aux dessins qui l'accompagnent, dans lesquels:
- la figure 1 est une vue en coupe d'une fraction d'un connecteur suivant un mode particulier de réalisation de l'invention et des éléments qui lui sont associés et sont concernés par l'invention;
- la figure 2 est une vue de détail en perspective à grande échelle montrant un des contacts du connecteur de la figure 1 à l'état de repos ; et
- la figure 3 est une vue en perspective d'un support isolant de connecteur utilisable pour la mise en oeuvre de l'invention.

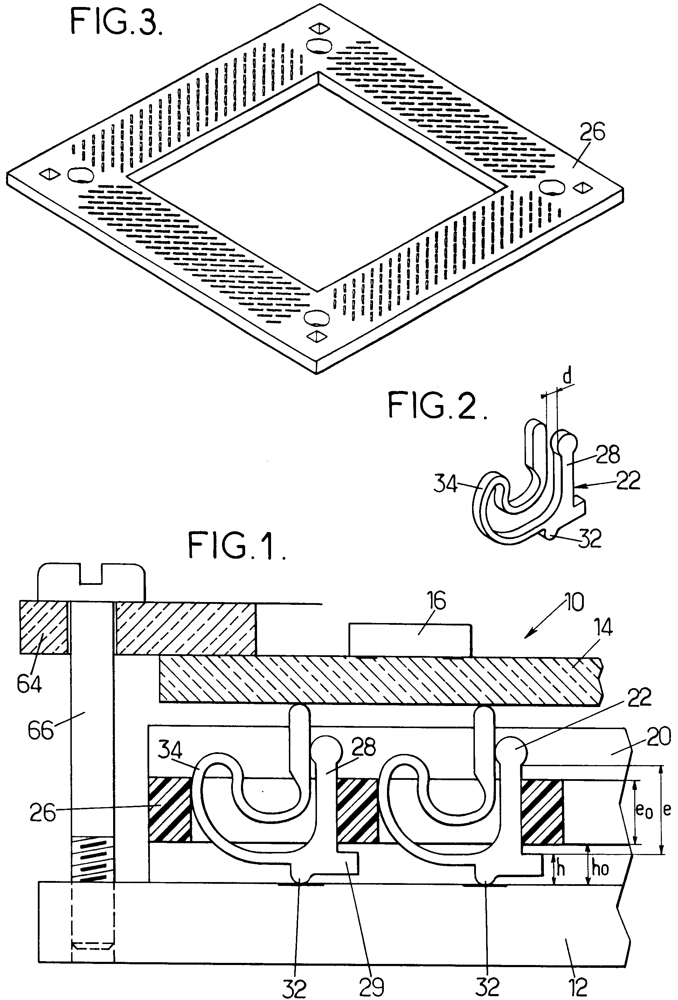

Le connecteur 10 montré en figure 1 a une constitution générale similaire à celle décrite dans le document FR-A-2 669 149 auquel on pourra se reporter. Il est destiné à être monté sur une carte de circuit imprimé 12 à relier à un substrat 14 de circuits électroniques actifs. Le substrat peut notamment être constitué par une plaquette céramique multi-couches (surmontée ou non de structures couche mince) destinée à recevoir des puces de circuit intégré 16. Cependant, l'invention est également applicable lorsque le substrat est destiné à recevoir un seul circuit intégré et/ou est en matériau autre que céramique (par exemple organique).

Le connecteur comporte un support isolant 20. Dans le cas représenté en Figure 3, ce support est en forme de cadre.

Dans le support isolant 20 sont ménagés des passages alignés en rangées destinés à recevoir des contacts qui peuvent avoir des natures différentes. Les contacts 22 montrés en figures 1 et 2 sont destinés à transmettre des signaux. D'autres contacts peuvent être prévus pour établir des connexions équipotentielles, par exemple de masse ou d'alimentation.

Chaque contact 22 (figure 2) est généralement réalisé par découpe d'un feuillard en matériau conducteur et ayant une bonne élasticité, par exemple en bronze au béryllium. Il peut être regardé comme ayant une branche 28 relativement rigide d'accrochage sur le support et une branche relativement souple 34 de jonction.

Chaque passage de réception d'un contact est délimité par deux cloisons 26 n'occupant pas toute la hauteur du support isolant 20. Ces cloisons, toutes de la même hauteur, forment deux épaulements de butée séparés d'un intervalle déterminé eo. Lorsque le support isolant est monté sur la carte 12, l'épaulement le plus proche de la première face du support, qui s'applique contre la carte 12, est à une hauteur ho par rapport à cette dernière.

La branche rigide 28 de chaque contact est dirigée le long du passage correspondant et elle comporte également deux épaulements de butée en regard, séparés d'un intervalle déterminé e légèrement supérieur à eo (par exemple représentant 1,1 à 1,4 fois eo, permettant au contact de "flotter" dans le passage.

Dans le mode de réalisation illustré en figures 1 et 2, l'épaulement de butée le plus proche de la première face du support est formé par un moignon 29 transversal à la direction de la branche rigide 28. L'autre épaulement est constitué par l'amorce d'un renflement 22, de forme arrondie, pour éviter l'arc-boutement du contact lorsqu'on l'introduit dans un passage.

La branche rigide comporte, à proximité immédiate de son raccordement avec la branche souple, un renflement 32 d'appui (et éventuellement de soudage) sur une piste de la carte 12. La distance h entre l'épaulement le plus proche de la première face et l'extrémité du renflement 32 est inférieure à ho. Par exemple h est compris entre 0,6 ho et 0,9 ho.

La branche souple 34 présente une forme générale en S. Son extrémité proximale se raccorde à la branche rigide d'accrochage 28, à proximité du renflement 32.

La forme libre du contact 22, montrée en figure 2, est telle que l'extrémité distale de la branche souple soit latéralement à une distance d de l'extrémité haute de la branche rigide d'accrochage 28. Mais les dimensions transversales des passages de réception dans le support 20 sont telles que la pression exercée par les bords du passage amène la branche souple 34 dans la disposition montrée en figure 1, c'est-à-dire en contact avec la branche d'accrochage 28. Toutefois il n'est pas indispensable de remplir cette condition. La forme de la partie souple 34 est également telle que la pression exercée par le substrat 14, lorsqu'il est amené en appui contre le support 20, assure avantageusement la venue en appui du dernier coude de la branche souple contre l'extrémité proximale de cette même branche. On réalise ainsi un court-circuit réduisant le temps de parcours des signaux.

Des moyens permettant d'appliquer le substrat 14 contre le support 20 comportent, dans le cas illustré sur la figure 1, un ensemble déplaçable ayant une plaque de pression 64 et des vis 66. Des ressorts non représentés sont généralement interposés entre la vis et la plaque 64.

Du fait que la distance h est inférieure à ho, le risque d'exercer une pression sur le moignon 29 est écarté. Du fait que e est supérieur à eo, la position de la branche rigide 28 de chaque contact s'ajuste automatiquement jusqu'à ce que l'effort exercé par l'intermédiaire de la branche souple 34 sur la branche rigide équilibre exactement la force de réaction s'exerçant sur le renflement 32. On réduit ainsi les contraintes subies par les contacts et on les équilibre dans l'ensemble du connecteur.

Il y a ainsi une garantie de force de contact tant sur le substrat que sur le circuit imprimé en dépit des variations dimensionnelles de la distance entre substrat et circuit imprimé, liées en particulier, mais de façon non-exclusive, aux imprécisions de planéité.

## Revendications

1. Connecteur intermédiaire destiné à être monté sur une carte de circuit imprimé (12) de façon qu'une première face du connecteur s'appuie sur la carte et à recevoir, sur une seconde face, un substrat (14) de circuit électronique en reliant des plots de contact prévus sur la face du substrat (14) qui est en regard de la carte à des pistes de la carte (12), le dit connecteur comprenant
un support isolant (20) dans lequel sont ménagés des passages régulièrement espacés et
des contacts électriques de signal (22), chacun destiné à relier un plot et une piste, disposés dans certains au moins des passages,
dans lequel chacun d'au moins certains des contacts (22) est constitué par un feuillard découpé, ayant une branche (26) rigide d'accrochage sur le support et une branche souple en forme de S, dont l'extrémité proximale est solidaire de la branche rigide et dont l'extrémité distale fait saillie au-delà de la face supérieure du support, la branche souple ayant des courbures au repos telles que l'extrémité distale soit alors écartée de la branche rigide et le passage de réception du contact ayant des dimensions telles qu'il déforme la branche souple lors de l'insertion du contact dans le support jusqu'à amener la partie distale en liaison avec la branche rigide, pour constituer un court-circuit,
caractérisé en ce que le passage est délimité par une cloison destinée à recevoir l'appui coulissant de la branche rigide et présentant des épaulements de butée séparées d'un intervalle déterminé (eo), la surface de butée la plus proche de la première face étant à une hauteur prédéterminée ho par rapport à cette dernière,
en ce que la branche rigide d'accrochage, dirigée le long du passage, comporte deux épaulements de butée en regard, séparés d'un intervalle déterminé (e) supérieur à (eo),
et en ce que la saillie (h) du contact à partir de l'épaulement le plus proche de la seconde face est inférieure à (ho).

2. Connecteur selon la revendication 1, caractérisé en ce que l'épaulement de butée de la branche rigide le plus proche de la première face du support est formé sur un moignon (29) transversal à la direction de la branche rigide (28) et l'autre épaulement de butée est constitué par l'amorce d'un renflement terminal (22) du contact.

3. Connecteur selon la revendication 1, caractérisé en ce que la branche souple se raccorde à la branche rigide d'accrochage (28) à proximité d'un renflement (32) d'appui sur la carte (12).

4. Connecteur selon la revendication 1, 2 ou 3, caractérisé en ce que l'intervalle (e) qui sépare les deux épaulements de butée de la branche rigide (28) est compris entre 1,1 et 1,4 fois l'intervalle (eo).

5. Connecteur selon l'une quelconque des revendications précédentes, caractérisé en ce que la saillie (h) est comprise entre 0,6 et 0,9 fois ladite hauteur prédeterminée (ho).
